(19) **Europäisches Patentamt / European Patent Office / Office européen des brevets**

(11) **EP 4 694 618 A1**

(12) **DEMANDE DE BREVET EUROPEEN**

(43) Date de publication:
**11.02.2026 Bulletin 2026/07**

(21) Numéro de dépôt: **25191129.3**

(22) Date de dépôt: **22.07.2025**

(51) Classification Internationale des Brevets (IPC):
**H10D 48/00** *(2025.01)*    **H10D 62/10** *(2025.01)*
**H10D 64/27** *(2025.01)*    B82Y 10/00 *(2011.01)*

(52) Classification Coopérative des Brevets (CPC):
**H10D 48/3835; H10D 62/115; H10D 62/124;**
B82Y 10/00; H10D 64/27

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH LA MA MD TN**

(30) Priorité: **23.07.2024 FR 2408114**

(71) Demandeur: **Commissariat à l'Energie Atomique et aux Energies Alternatives
75015 Paris (FR)**

(72) Inventeurs:
• **MARTINEZ I DIAZ, Biel**
  **38054 GRENOBLE CEDEX 09 (FR)**
• **MAURO, Lorenzo**
  **38054 GRENOBLE CEDEX 09 (FR)**
• **NIQUET, Yann-Michel**
  **38054 GRENOBLE CEDEX 09 (FR)**

(74) Mandataire: **Cabinet Beaumont
4, Place Robert Schuman
B.P. 1529
38025 Grenoble Cedex 1 (FR)**

(54) **DISPOSITIF QUANTIQUE A QUBIT DANS UNE HETEROSTRUCTURE**

(57) Dispositif quantique (200) à qubits, comprenant :
- un empilement (210) s'étendant dans un plan, incluant des première, deuxième et troisième couches (212, 214, 216) semiconductrices sur un substrat semiconducteur (102), la deuxième couche étant adaptée à confiner un porteur de charge, et les semiconducteurs des première et troisième couches présentant chacun un paramètre de maille différent de celui du deuxième semiconducteur ;
- une structure de grille (120) positionnée sur une première face (210A) de l'empilement et adaptée à contrôler le déplacement du porteur de charge confiné dans la deuxième couche ;
- un renfoncement (222) s'étendant à partir de la première face à travers les troisième et deuxième couches, situé à une distance D d'un centre de la structure de grille dans le plan et ayant une profondeur T tel que le rapport D/T soit compris dans l'intervalle ]0;10].

**Fig. 2**

EP 4 694 618 A1

## Description

Domaine technique

La présente description concerne de façon générale le domaine de l'information quantique ou de l'informatique quantique. Elle concerne en particulier les dispositifs quantiques à bits quantiques, appelés "quantum bits" en anglais, ou "qubits", c'est-à-dire des unités élémentaires d'information quantique.

De manière avantageuse, la présente description s'applique au développement de processeurs quantiques dans lesquels des qubits sont encodés dans des régions semiconductrices, en particulier pour des qubits de spin où l'information quantique est encodée dans les états de spin d'un porteur de charge (électron ou trou) confiné dans une région semiconductrice par des potentiels électrostatiques délivrés par des grilles de contrôle.

Technique antérieure

L'informatique quantique est basée sur l'utilisation d'un état quantique à deux niveaux mesurables comme vecteur d'information, appelé bit quantique ou, en anglais, "quantum bit" ou "qubit". Des lois et propriétés de la mécanique quantique, telles que la superposition, l'intrication, et la mesure sont exploitées afin d'exécuter des algorithmes. Un dispositif quantique comprenant des qubits permet de manipuler l'état quantique de ces qubits.

Les qubits de spin ou de charge peuvent être formés dans un semiconducteur. Les technologies semiconductrices telles que les technologies CMOS, de l'anglais Complementary Metal Oxide Semi-conductor, et notamment des technologies dérivées des transistors à effet de champ, ou transistors FET, de l'anglais Field Effect Technology, ont été étudiées pour la réalisation de qubits. Dans de tels qubits, des électrons ou des trous (porteurs de charge) sont confinés à des températures cryogéniques dans des structures de confinement de tailles nanométriques définies une région d'un semiconducteur, qui peut être le silicium. Ces structures de confinement correspondent à des boîtes quantiques, également appelées "quantum dots" en anglais. Une boîte quantique se comporte comme un puits de potentiel confinant un ou plusieurs porteurs de charge dans la région de semiconducteur.

Pour confiner un porteur de charge dans la boîte quantique formée dans la région de semiconducteur, et contrôler cette boîte quantique, il est nécessaire de pouvoir ajuster la profondeur énergétique de cette boîte quantique dans le semiconducteur, c'est-à-dire le niveau minimum d'énergie potentielle, ou potentiel, de la boîte quantique. De plus, pour contrôler l'occupation, en termes de nombre de charges électriques, de plusieurs boîtes quantiques formées côte à côte dans la région de semiconducteur, en plus du contrôle du potentiel, il est nécessaire d'ajuster la hauteur énergétique des barrières tunnel, ou barrières à effet tunnel, c'est-à-dire le niveau maximum des barrières tunnel, qui séparent les boîtes quantiques. Le contrôle des barrières tunnel et du potentiel est généralement réalisé par l'intermédiaire de tensions appliquées sur des grilles de contrôle électrostatique. Par exemple, pour transférer un porteur de charge d'une boîte quantique à une autre, technique connue sous le terme "hopping" en anglais, on peut agir sur certaines de ces grilles de contrôle pour baisser la hauteur de la barrière tunnel entre les deux boîtes quantiques et/ou augmenter le potentiel de ces boîtes quantiques.

Dans un dispositif quantique à boîtes quantiques dans un semiconducteur, certaines grilles de contrôle (« plunger gate » en anglais) sont généralement disposées au-dessus de la région de semiconducteur recouverte d'une couche de matériau isolant formant l'oxyde de grille. Le confinement des porteurs de charge est sensible à la présence de charges électriques piégées principalement aux interfaces entre le semiconducteur et le matériau isolant. Ceci crée un désordre de charge, qui est une cause de variabilité entre les qubits.

Or, un processeur quantique comporte en général un grand nombre de qubits, et la réalisation d'un tel nombre de qubits au sein d'un même dispositif quantique pose des problèmes technologiques, en particulier des problèmes de gestion de la variabilité entre les qubits.

Afin de répondre à cette problématique de désordre de charge et de variabilité, les concepteurs de dispositifs quantiques à qubits se tournent vers des hétérostructures de semiconducteurs, c'est-à-dire des structures obtenues par un empilement de plusieurs couches semiconductrices, dont au moins deux couches semiconductrices sont en des semiconducteurs différents, l'une de ces couches semiconductrices étant destinée à former une région de confinement quantique, ou région de confinement, d'un (ou plusieurs) porteur(s) de charge, formant un qubit. La région de confinement est par exemple une boîte quantique. Les différents semiconducteurs ont généralement des énergies de bande interdite différentes et des tailles de maille différentes.

Un champ magnétique est appliqué pour séparer les états de spin et définir le qubit. Ce champ magnétique statique est de préférence aligné parallèlement au plan des couches semi-conductrices dans le cas d'hétérostructures Ge/SiGe afin de limiter les interactions dites « hyperfines » avec les spins nucléaires dans les couches semi-conductrices. La manipulation du qubit peut être obtenue en appliquant des champs électriques ou magnétiques RF (radiofréquence) de fréquence égale au gap d'énergie entre les différents états de spin, ou par déplacement (« hopping » en anglais) entre boîtes quantiques lorsque le champ magnétique est aligné parallèlement au plan des couches semi-conductrices.

Les dispositifs quantiques, y compris les dispositifs quantiques à hétérostructure de semiconducteurs, sont souvent sensibles à un désalignement, même minime, du champ magnétique par rapport au plan des couches semiconductrices. Un tel désalignement peut créer des problèmes dans le cas de manipulation de spin par « hopping » entre boîtes quantiques.

Résumé de l'invention

Il existe un besoin d'un dispositif quantique permettant de pallier tout ou partie des inconvénients précités, en particulier de répondre aux problèmes de variabilité et de sensibilité du dispositif quantique.

Un mode de réalisation pallie tout ou partie des inconvénients des dispositifs quantiques connus.

Un mode de réalisation prévoit un dispositif quantique à qubits, le dispositif quantique comprenant :

- un empilement de couches semiconductrices s'étendant dans un plan (XY), l'empilement incluant au moins une première couche d'un premier semiconducteur sur un substrat semiconducteur, une deuxième couche d'un deuxième semiconducteur sur la première couche, et une troisième couche d'un troisième semiconducteur sur la deuxième couche, la deuxième couche étant adaptée à confiner un porteur de charge, et les premier et troisième semiconducteurs présentant chacun un paramètre de maille différent du paramètre de maille du deuxième semiconducteur, de sorte que la deuxième couche présente une contrainte ($\varepsilon$) dans le plan, la première couche ayant en outre une contrainte résiduelle ($\varepsilon r$) dans le plan ;
- une structure de grille, comprenant au moins une grille de contrôle, positionnée au-dessus d'une première face de l'empilement, ladite structure de grille étant adaptée à contrôler le déplacement du porteur de charge confiné dans la deuxième couche ; et
- au moins un renfoncement s'étendant à partir de la première face à travers au moins les troisième et deuxième couches, ledit au moins un renfoncement étant situé à une distance (D, D'), non nulle, d'un centre de la structure de grille dans le plan (XY) et ayant une profondeur (T, T') tel que le rapport de la distance (D, D') sur la profondeur (T, T') soit compris entre une valeur strictement supérieure à 0 et inférieure ou égale à 10.

Selon un mode de réalisation particulier, le plan (XY) inclut une première direction (X) et une deuxième direction (Y), le au moins un renfoncement comprenant au moins un premier renfoncement étendu dans la deuxième direction (Y) ou deux premiers renfoncements positionnés de part et d'autre de la structure de grille dans la première direction (X).

Selon un mode de réalisation particulier, le au moins un renfoncement comprend en outre au moins un deuxième renfoncement étendu dans la première direction (X) ou deux deuxièmes renfoncements de part et d'autre de la structure de grille dans la deuxième direction (Y).

Selon un mode de réalisation particulier, le au moins un deuxième renfoncement inclut au moins une deuxième tranchée et/ou est positionné en un premier bord de l'empilement.

Selon un mode de réalisation particulier, le au moins un premier renfoncement inclut au moins une première tranchée et/ou est positionné en un deuxième bord de l'empilement.

Selon un mode de réalisation particulier, pour chaque renfoncement :

- la distance (D, D') est inférieure ou égale à 2,5 $\mu$m, et par exemple supérieure ou égale à 0,5 $\mu$m ; et/ou
- la profondeur (T, T') est supérieure ou égale à 0,25 $\mu$m, et par exemple inférieure ou égale à 1 $\mu$m ; et/ou
- une longueur (W ; W') de chaque renfoncement est supérieure ou égale à la distance (D ; D').

Selon un mode de réalisation particulier, le au moins un renfoncement comprend un renfoncement périphérique s'étendant sur toute la périphérie de l'empilement autour de la structure de grille, ledit renfoncement périphérique définissant un ilot correspondant à une portion non périphérique de l'empilement.

Selon un mode de réalisation particulier, le au moins une premier renfoncement est localisé dans l'ilot.

Selon un mode de réalisation particulier, le au moins un deuxième renfoncement est localisé dans l'ilot.

Selon un mode de réalisation particulier, le renfoncement périphérique a une seule profondeur, par exemple ladite profondeur est supérieure ou égale à 0,25 $\mu$m, ou le renfoncement périphérique présente plusieurs profondeurs (Tx, Ty1, Ty2) différentes, par exemple lesdites profondeurs sont toutes supérieures ou égales à 0,25 $\mu$m.

Selon un mode de réalisation particulier, l'une parmi la contrainte ($\varepsilon$) et la contrainte résiduelle ($\varepsilon r$) est une contrainte en compression, tandis que l'autre est une contrainte en tension.

Selon un mode de réalisation particulier :

- les couches semiconductrices de l'empilement sont des couches épitaxiales ; et/ou
- l'énergie de bande interdite du deuxième semiconducteur est inférieure à l'énergie de bande interdite de chacun des premier et troisième semiconducteurs ; et/ou
- les premières et troisièmes couches forment chacune une barrière de potentiel de confinement vis-à-vis du porteur de charge dans la deuxième couche ; et/ou
- les premier et troisième semiconducteurs sont en un alliage silicium-germanium et le deuxième semiconducteur est le germanium.

Selon un mode de réalisation particulier, ledit au moins un renfoncement est rempli totalement ou en partie par au moins un matériau, de préférence diélectrique.

Selon un mode de réalisation, chaque renfoncement est à une distance non nulle du bord de la structure de grille.

Cette caractéristique présente au moins les avantages suivants :

- éviter de dégrader la structure de grille, et par exemple ainsi éviter de dégrader la qualité des qubits ;
- permettre d'améliorer le contrôle des contraintes selon la première et/ou la deuxième direction, en particulier permettre d'améliorer le relâchement des contraintes selon la première et/ou la deuxième direction, ce qui préserve l'intégrité mécanique de la structure de grille ;
- éviter de former des défauts d'impuretés sur la structure de grille lors de la gravure pour former chaque renfoncement.

Il est également proposé un procédé de réalisation d'un dispositif quantique à qubits, comprenant au moins :

- réalisation d'un empilement de couches semiconductrices s'étendant dans un plan (XY), l'empilement incluant au moins une première couche d'un premier semiconducteur sur un substrat semiconducteur, une deuxième couche d'un deuxième semiconducteur sur la première couche, et une troisième couche d'un troisième semiconducteur sur la deuxième couche, la deuxième couche étant adaptée à confiner un porteur de charge, et les premier et troisième semiconducteurs présentant chacun un paramètre de maille différent du paramètre de maille du deuxième semiconducteur, de sorte que la deuxième couche présente une contrainte ($\varepsilon$) dans le plan, la première couche ayant en outre une contrainte résiduelle ($\varepsilon r$) dans le plan ;
- réalisation d'une structure de grille, comprenant au moins une grille de contrôle, positionnée au-dessus d'une première face de l'empilement, ladite structure de grille étant adaptée à contrôler le déplacement du porteur de charge confiné dans la deuxième couche ; et
- réalisation d'au moins un renfoncement s'étendant à partir de la première face à travers au moins les troisième et deuxième couches, ledit au moins un renfoncement étant situé à une distance (D, D'), non nulle, d'un centre de la structure de grille dans le plan (XY) et ayant une profondeur (T, T') tel que le rapport de la distance (D, D') sur la profondeur (T, T') soit compris entre une valeur strictement supérieure à 0 et inférieure ou égale à 10.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1A est une vue en trois dimensions schématique représentant un exemple de dispositif quantique ;

la figure 1B est une vue en coupe schématique du dispositif quantique de la figure 1A ;

la figure 2 est une vue en coupe schématique et partielle représentant un dispositif quantique selon un mode de réalisation ;

la figure 3 représente une courbe donnant des valeurs de la contrainte dans la première direction en fonction de la cote dans la première direction par rapport au centre d'une structure de grille d'un dispositif quantique selon un mode de réalisation ; et

La figure 4 représente des courbes donnant des valeurs de la contrainte et du tenseur gyromagnétique dans la première direction en fonction respectivement de la largeur, la distance et la profondeur des renfoncements d'un dispositif quantique selon un mode de réalisation ;

la figure 5 représente des courbes donnant des valeurs de fréquence de Rabi en fonction de l'angle de désalignement d'un champ magnétique par rapport au plan des couches semiconductrices de deux dispositifs quantiques ;

la figure 6A et la figure 6B sont des vues de dessus et en coupe représentant un dispositif quantique selon un autre mode de réalisation ;

la figure 7A et la figure 7B sont des vues de dessus et en coupe représentant un dispositif quantique selon un autre mode de réalisation ;

la figure 8 est une vue de dessus représentant un dispositif quantique selon un autre mode de réalisation ;

la figure 9 est une vue de dessus représentant un dispositif quantique selon un autre mode de réalisation ;

la figure 10A, la figure 10B et la figure 10C sont des vues de dessus et en coupe représentant un dispositif quantique selon un autre mode de réalisation ;

la figure 11A, la figure 11B et la figure 11C sont des vues de dessus et en coupe représentant un dispositif quantique selon un autre mode de réalisation ;

la figure 12A et la figure 12B sont des vues de dessus et en coupe représentant un dispositif quantique selon un autre mode de réalisation ;

la figure 13 est une vue de dessus représentant un dispositif quantique selon un autre mode de réalisation ;

la figure 14 est une vue de dessus représentant un dispositif quantique selon un autre mode de réalisation.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les détails des structures quantiques et des grilles de contrôle, ainsi que leur procédé de fabrication, n'ont pas été détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % ou à 10° près, de préférence à 5 % ou à 5° près.

Dans la description qui suit, sauf indication contraire, lorsque l'on fait référence à un substrat, il est fait référence à un substrat semiconducteur, lorsque l'on fait référence à une région, il est fait référence à une région semiconductrice, et lorsque l'on fait référence à une couche, il est fait référence à une couche semiconductrice. En outre, lorsque l'on fait référence à un dispositif, il est fait référence, sauf indication contraire, à un dispositif quantique.

Dans la description qui suit, pour les couches semiconductrices, une longueur correspond à une dimension dans une première direction du plan des couches semiconductrices et une largeur correspond à une dimension dans une deuxième direction de ce plan, orthogonale à la première direction, tandis que pour les renfoncements ou les portions de renfoncements, une largeur correspond à la plus petite dimension dans ce plan et une longueur correspond à la plus grande dimension dans ce plan. Pour tous les éléments, une épaisseur ou une profondeur correspond à une dimension dans une direction perpendiculaire aux première et deuxième directions. Le plan correspond au plan XY repéré dans les figures. La première direction correspond à la direction horizontale X repérée dans les figures. La deuxième direction correspond à la direction horizontale Y repérée dans les figures. La direction perpendiculaire correspond à la direction verticale Z repérée dans les figures.

Dans une configuration particulière, ces directions peuvent être alignées avec les directions cristallines des semi-conducteurs utilisés. Par exemple, l'axe Z peut être parallèle à la direction (001), l'axe X peut être parallèle à la direction (100) et l'axe Y peut être parallèle à la direction (010). En variante, l'axe X pourrait être parallèle à la direction (110) ou l'axe Y pourrait être parallèle à la direction (110).

Dans l'ensemble de la description, le terme "sur" est utilisé sans distinction de l'orientation dans l'espace de l'élément auquel se rapporte ce terme. Par exemple, dans l'expression ou la caractéristique "sur une face d'une couche", cette face n'est pas nécessairement orientée vers le haut mais peut correspondre à une face orientée selon n'importe quelle direction. En outre, la disposition d'un premier élément sur un deuxième élément doit être comprise comme pouvant correspondre à la disposition du premier élément directement contre le deuxième élément, sans aucun élément intermédiaire entre les premier et deuxième éléments, ou bien comme pouvant correspondre à la disposition du premier élément sur le deuxième élément avec un ou plusieurs éléments intermédiaires disposés entre les premier et deuxième éléments.

Dans l'ensemble de la description, le terme "centre" d'une structure ne se réfère pas nécessairement au milieu de cette structure, mais signifie plus largement un point éloigné des bords de la structure.

Dans l'ensemble de la description, un renfoncement désigne une portion creusée dans l'épaisseur de l'empilement de couches semiconductrices. On peut parler de creux ou de dépression. Un renfoncement peut être localisé en un ou plusieurs bords de l'empilement. Un renfoncement peut être à distance des bords de l'empilement, formant ainsi une tranchée.

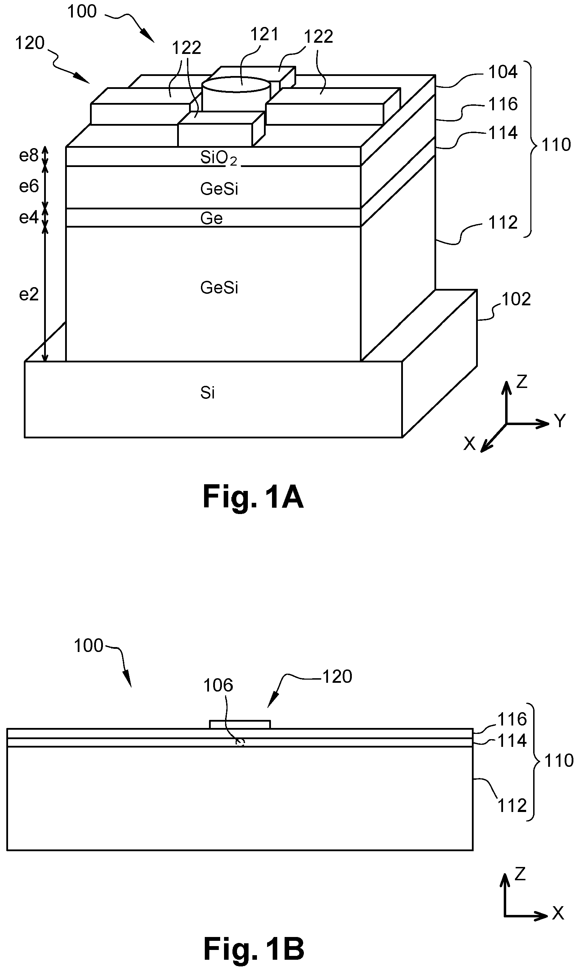

La figure 1A est une vue en trois dimensions schématique représentant un exemple de dispositif quantique 100. La figure 1B est une vue en coupe schématique et partielle du dispositif quantique 100 de la figure 1A. Dans la figure 1B on a représenté le dispositif quantique 100 dans un plan de coupe XZ.

La figure 1A représente en particulier un exemple d'empilement 110 de couches semiconductrices formées à partir d'un substrat 102.

Le substrat 102 correspond par exemple à un wafer, ou plaquette, à base de Silicium (Si), Germanium (Ge), Arséniure de Gallium (GaAs), ou tout autre semiconducteur adapté.

Les couches de l'empilement 110 sont des couches épitaxiales, c'est-à-dire des couches formées l'une sur l'autre par des étapes de croissance épitaxiale, ou épitaxie, à partir du substrat 102.

L'empilement 110 représenté en figure 1A comprend trois couches semiconductrices :

- une couche 112 d'un premier semiconducteur sur le substrat 102 ;
- une couche 114 d'un deuxième semiconducteur sur la couche 112 ; et
- une couche 116 d'un troisième semiconducteur sur la couche 114.

L'ensemble de ces couches, c'est-à-dire l'empilement 110, forme une hétérostructure.

L'énergie de bande interdite du deuxième semiconducteur peut être inférieure à celles des premier et troisième semiconducteurs, par exemple tel que les premières et troisièmes couches 112 et 116 forment des barrières de potentiel de confinement vis-à-vis d'électrons ou de trous destinés à être localisés dans une ou plusieurs régions de confinement formées dans la deuxième couche 114.

De plus, les premier et troisième semiconducteurs présentent avantageusement chacun une taille de maille différente de la taille de maille du deuxième semiconducteur, de manière à induire des contraintes dans la deuxième couche 114.

Ainsi, un ou plusieurs porteurs de charge (électrons ou trous) sont destinés à être confinés dans la deuxième couche 114, formant un ou plusieurs qubits, cette deuxième couche étant généralement contrainte. On a représenté en figure 1B un qubit 106 dans la deuxième couche 114, étant entendu qu'il peut y avoir plusieurs qubits dans cette deuxième couche.

Dans l'exemple des figures 1A et 1B, les premier et troisième semiconducteurs sont un alliage Silicium-Germanium (SiGe) et le deuxième semiconducteur est du Ge. La deuxième couche semiconductrice 114 est alors adaptée à confiner un (ou plusieurs) qubit(s) de spin de trou. Les alliages SiGe ayant une taille de maille plus petite que celle du Ge, une contrainte compressive est induite dans le Ge.

Cependant, la deuxième couche semiconductrice pourrait être adaptée à confiner un (ou plusieurs) qubit(s) de spin d'électron, par exemple le deuxième semiconducteur peut être du Si. Selon une autre variante, la deuxième couche 114 peut comporter du GaAs.

L'épaisseur e2 de la couche 112 est par exemple supérieure ou égale à un micromètre ($\mu$m), par

exemple de quelques micromètres. Une épaisseur importante de la couche 112 peut être nécessaire dans certains cas pour relâcher des contraintes induites par des différences de mailles entre la couche 112 et le substrat 102. La composition stœchiométrique de la couche 112 peut varier pendant la croissance épitaxiale afin d'obtenir une composition désirée avec un état de contrainte souhaité.

L'épaisseur e4 de la couche 114 est par exemple comprise entre 5 et 50 nanomètres (nm), voire entre 5 et 20 nm, par exemple égale à environ 10 nm.

L'épaisseur e6 de la couche 116 est par exemple comprise entre 10 et 100 nanomètres (nm), voire entre 20 et 60 nm.

Une structure de grille 120 comprenant une ou plusieurs grilles de contrôle (« plunger gate ») électriquement conductrices est positionnée au-dessus de l'empilement 110.

Dans l'exemple représenté en figure 1A, la structure de grille 120 comprend :

- une grille de contrôle centrale 121 qui est par exemple une grille de contrôle du potentiel du qubit 106 pour le confiner sous cette grille, créant un point quantique, le qubit pouvant sinon se déplacer dans la deuxième couche semiconductrice 114 ; et
- des grilles de contrôle périphériques 122, autour de la grille de contrôle centrale 121, qui sont par exemple des grilles de contrôle de barrières tunnels entre des qubits voisins, et qui peuvent aussi contribuer à confiner le qubit 106 dans le point quantique.

Le dispositif quantique 100 peut aussi comprendre une ou plusieurs grilles arrière (non représentées), en dessous du substrat 102 ou de la couche semiconductrice 112.

Une couche isolante 104 est positionnée entre les grilles de contrôle 121, 122 et l'empilement 110. La couche isolante 104 est par exemple en un oxyde tel que le dioxyde de silicium ($SiO_2$) ou de l'oxyde d'aluminium. La couche isolante 104 forme par exemple un oxyde de grille. L'épaisseur e8 de la couche isolante 104 est avantageusement inférieure ou égale à 20 nm, par exemple comprise entre 2 et 20 nm, par exemple égale à environ 5 nm.

Dans la figure 1B, pour simplifier celle-ci, le dispositif quantique 100 a été représenté sans le substrat 102, et sans la couche isolante 104. De plus, on a modifié les échelles par rapport à la figure 1A, la structure de grille 120 étant schématisée par un simple rectangle au-dessus du qubit 106.

Bien que non représenté, un générateur de champ magnétique adapté à exposer le qubit 106 à un champ magnétique B homogène peut fonctionner conjointement avec le dispositif quantique 100.

Pour manipuler un qubit de spin, et lorsque les premier et troisième semi-conducteurs comportent du SiGe et le deuxième semi-conducteur comporte du Ge, le champ magnétique B est de préférence orienté dans un plan parallèle au plan XY des couches semiconductrices, par exemple pour permettre d'appliquer au qubit une énergie ΔE suffisante pour le faire passer d'un état de spin à un autre, selon l'effet Zeeman.

La manipulation du spin peut exploiter la résonance de spin électronique, ou ESR pour Electronic Spin Resonance, pour un spin d'électron. La manipulation du spin peut avantageusement exploiter le couplage spin orbite dans le qubit, notamment dans la technique dite EDSR, de l'anglais Electronic Dipole Spin Resonance. D'autres techniques existent.

La relation entre le champ magnétique B et l'énergie ΔE est définie par l'équation suivante :

[Math 1]

$$\Delta E = \mu_B |g \cdot B|$$

où $\mu_B$ est le magnéton de Bohr et g est le tenseur gyromagnétique.

L'énergie ΔE et le champ magnétique B sont des vecteurs ayant chacun des composantes dans les directions X, Y et Z, et le tenseur gyromagnétique g peut s'exprimer sous forme de la matrice suivante :

[Math 2]

$$g = \begin{pmatrix} g_x & 0 & 0 \\ 0 & g_y & 0 \\ 0 & 0 & g_z \end{pmatrix}$$

où $g_x$, $g_y$ et $g_z$ sont les composantes du tenseur gyromagnétique dans chacune des directions X, Y et Z.

Dans certains cas, le tenseur gyromagnétique est très anisotropique, la composante $g_z$ du tenseur gyromagnétique étant généralement beaucoup plus grande que les composantes $g_x$ et $g_y$. Ceci a été constaté par exemple dans le cas de qubits de trou formés dans une couche en germanium. Par exemple, la composante $g_z$ est comprise entre 10 et 14, tandis que chaque composante $g_x$ et $g_y$ est comprise entre 0,02 et 0,2.

Par ailleurs, les inventeurs ont constaté que le fonctionnement des dispositifs quantiques était très sensible à un désalignement, même minime, du champ magnétique B par rapport au plan XY des couches semiconductrices, lorsque $g_z \gg g_x$ et $g_z \gg g_y$. Par exemple, un désalignement peut conduire à des erreurs de manipulation ou de lecture des qubits de spin, notamment des difficultés de manipulation des qubits de spin du fait que la manipulation du spin par EDSR devient inefficace.

Il a aussi été constaté que la manipulation du spin lors d'un déplacement d'un porteur de charge entre boîtes quantiques, "hopping" en anglais, pouvait être impacté par un tel désalignement.

En outre, il a été constaté que des variations, même petites, des composantes $g_x$ et $g_y$ du tenseur gyromagnétique pouvaient produire de grandes variabilités sur l'énergie ΔE qu'il faut pour faire passer un qubit de spin d'un état de spin à un autre, quand les valeurs de $g_x$ et $g_y$ sont faibles, par exemple dans le cas de qubits de trous dans du germanium.

Il existe donc un besoin d'un dispositif quantique à hétérostructure de semiconducteurs permettant de pallier tout ou partie des inconvénients précités, pour améliorer les performances de ce dispositif quantique, en particulier pour répondre aux problèmes de variabilité des qubits et de sensibilité à des paramètres extérieurs tel qu'un désalignement du champ magnétique appliqué à un qubit.

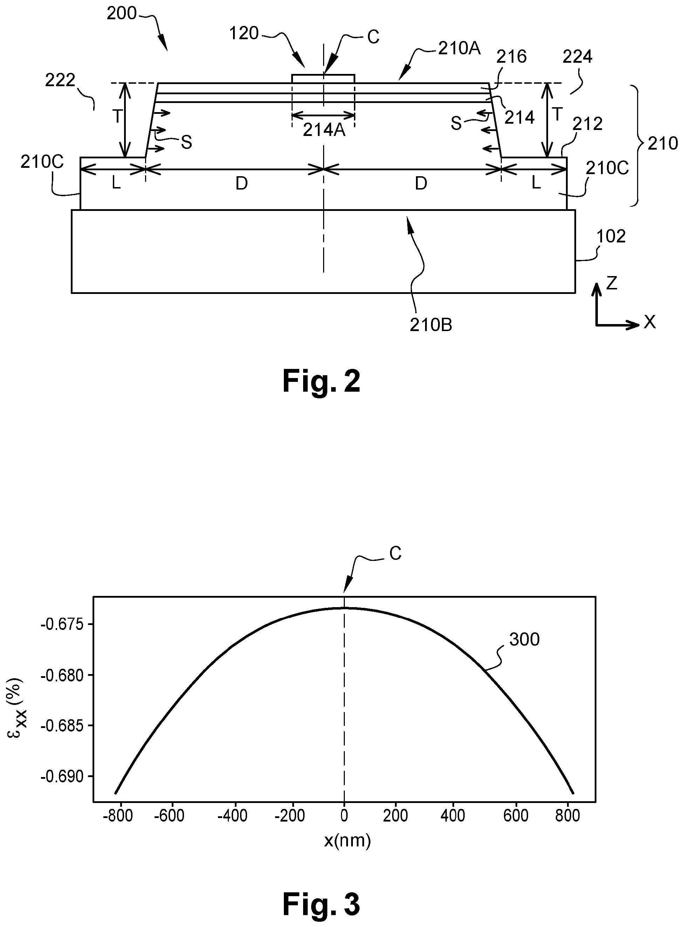

Dans les figures 2, 6A, 6B, 7A, 7B, 8, 9, 10A, 10B, 10C, 11A, 11B, 11C, 12A, 12B, et comme pour les figures 1A et 1B, le dispositif quantique comprend, sur un substrat 102, un empilement 210 de couches semiconductrices.

L'empilement 210 comprend trois couches semiconductrices :

- une première couche 212 d'un premier semiconducteur sur le substrat 102 ;
- une deuxième couche 214 d'un deuxième semiconducteur sur la couche 212 ; et
- une troisième couche 216 d'un troisième semiconducteur sur la couche 214.

L'ensemble de ces couches, c'est-à-dire l'empilement 210, forme une hétérostructure. La couche 212 est disposée entre le substrat 202 et la couche 214, et la couche 214 est disposée entre la couche 212 et la couche 216. Dans les exemples représentés, la face supérieure 210A (première face) de l'empilement 210 correspond à la face supérieure de la couche 216.

Les épaisseurs de ces couches peuvent être similaires à celles des couches 112, 114, 116 décrites en lien avec la figure 1A.

L'énergie de bande interdite du deuxième semiconducteur est avantageusement inférieure à celles des premier et troisième semiconducteurs, par exemple tel que les premières et troisièmes couches 212 et 216 forment des barrières de potentiel de confinement vis-à-vis d'électrons ou de trous destinés à être localisés dans la deuxième couche 214.

De plus, les premier et troisième semiconducteurs présentent avantageusement chacun une taille de maille différente de la taille de maille du deuxième semiconducteur, de manière à induire des contraintes dans la deuxième couche 214.

Un ou plusieurs porteurs de charge (électrons ou trous) sont destinés à être confinés dans la deuxième couche semiconductrice 214, formant un ou plusieurs qubits, cette deuxième couche semiconductrice étant contrainte.

Dans les figures 2, 6A, 6B, 7A, 7B, 8, 9, 10A, 10B, 10C, 11A, 11B, 11C, 12A, 12B, et comme pour la figure 1B, pour simplifier celles-ci, le dispositif quantique est représenté sans le substrat 102 (sauf dans la figure 2), et sans la couche isolante 104, et la structure de grille 120 est schématisée par un simple rectangle au-dessus du qubit (non représenté). La structure de grille 120 comprend une ou plusieurs grilles de contrôle du qubit.

La structure de grille 120 est positionnée autour d'un centre C de cette structure de grille. Le centre C est défini dans le plan XY de l'empilement 210.

L'ensemble formé par la structure de grille 120 et la portion 214A (repérée dans la figure 2 par une double flèche) de la deuxième couche 214 localisée sous cette structure de grille forme une structure quantique. Le centre C de la structure de grille peut ainsi correspondre au centre de la structure quantique.

On considère dans les figures 2, 6A, 6B, 7A, 7B, 8, 9, 10A, 10B, 10C, 11A, 11B, 11C, 12A, 12B que le deuxième semiconducteur est du Ge, et que les premier et troisième semiconducteurs sont un alliage SiGe, avec par exemple une proportion de 80% de germanium et de 20 % de silicium, la deuxième couche semiconductrice est alors adaptée à confiner un (ou plusieurs) qubit(s) de spin de trou. Cependant, les modes de réalisation peuvent s'appliquer à une deuxième couche semiconductrice adaptée à confiner un qubit de spin d'électron, par exemple être en Si, plus généralement à toute hétérostructure dont une couche semiconductrice est adaptée à confiner un (ou plusieurs) qubit(s) à porteur de charge, c'est-à-dire un (ou plusieurs) qubit(s) de spin (ou de charge) d'électrons (ou de trous).

De manière avantageuse, les premier et troisième semiconducteurs en SiGe ont la même identité de matériau, c'est-à-dire les mêmes pourcentages en Si et en Ge dans l'alliage. Ceci permet d'avoir sensiblement les mêmes contraintes dans les première et troisièmes couches.

Les alliages SiGe ayant une taille de maille plus petite que celle du Ge, une contrainte compressive est induite dans la deuxième couche 214 en Ge. Par ailleurs, la première couche 212 en SiGe présente une contrainte résiduelle en tension en raison du silicium utilisé dans le substrat 102.

Les contraintes indiquées dans les première et deuxième couches de l'empilement sont dans le plan XY de cet empilement, c'est-à-dire le plan des couches semiconductrices.

Au-delà des combinaisons de matériaux semiconducteurs indiquées ci-dessus, les modes de réalisation peuvent s'appliquer de façon générale à tout type d'hétérostructure obtenue par empilement de plusieurs couches de semiconducteurs, avec au moins deux matériaux semiconducteurs différents.

La figure 2 est une vue en coupe schématique et partielle représentant un dispositif quantique 200 selon un mode de réalisation.

Le dispositif quantique 200 de la figure 2 comprend des éléments communs avec le dispositif quantique 100 des figures 1A et 1B. Ces éléments communs ne seront pas décrits à nouveau ci-après.

Le dispositif quantique 200 de la figure 2 diffère du dispositif quantique 100 des figures 1A et 1B en ce qu'il comprend deux renfoncements 222 et 224 qui s'étendent dans l'empilement 210 à partir de la première face 210A (face supérieure) de cet empilement jusqu'en profondeur dans la première couche 212, c'est-à-dire à travers la troisième couche 216 et la deuxième couche 214, et partiellement dans la première couche 212, la profondeur dans l'empilement 210 étant désignée par la référence T.

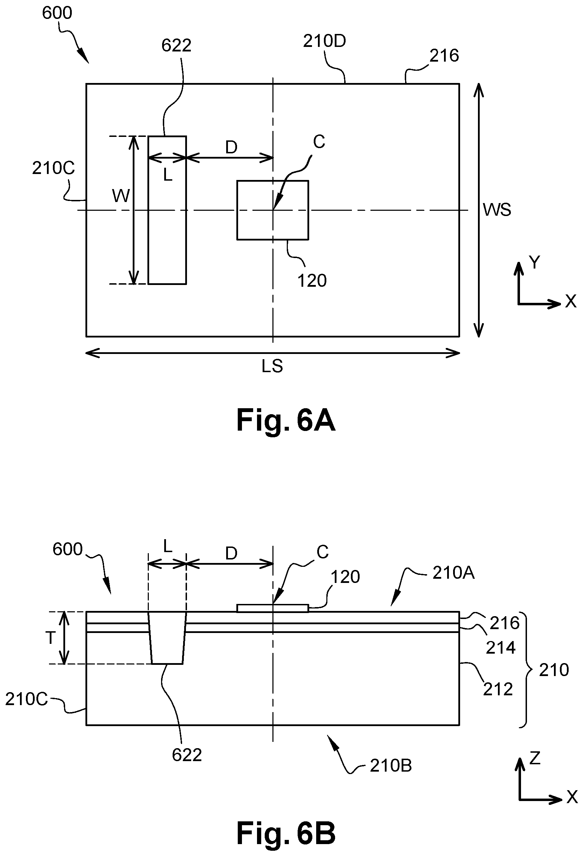

Chaque renfoncement 222, 224 est à une distance non nulle de la structure de grille 120, c'est-à-dire à une distance non nulle du bord de la structure de grille 120. Chaque renfoncement 222, 224 est à une distance D du centre C de la structure de grille 120. En outre, chaque renfoncement 222, 224 présente une largeur L dans la direction X et une longueur W dans la direction Y (visibles dans les figures 6A, 7A, 8, 9 12A). Dans la structure réalisée, ces dimensions sont telles que W >> 2D.

Dans l'exemple de la figure 2, les renfoncements 222 et 224 sont positionnés de part et d'autre de la structure de grille 120, et de plus, ils sont sensiblement à égale distance D du centre C, et ont sensiblement la même largeur L, la même longueur W, et la même profondeur T. Ceci n'est pas limitatif et deux renfoncements peuvent ne pas avoir les mêmes valeurs de distance D, de largeur L, de longueur W et/ou de profondeur T.

La première couche 212 présente une contrainte résiduelle $\varepsilon_r$ en tension. Par exemple, la composante $\varepsilon_{rxx}$ de la contrainte résiduelle est d'environ 0,26% dans la direction X, et la composante résiduelle $\varepsilon_{ryy}$ de la contrainte est d'environ 0,26% dans la direction Y. Les valeurs de ces composantes peuvent toutefois varier et être dépendantes des conditions de croissance. Les renfoncements 222, 224 ainsi introduits en profondeur dans la première couche 212 permettent de relâcher au moins partiellement la contrainte résiduelle $\varepsilon_{rxx}$ dans la direction X, comme indiqué par les flèches S dans la figure 2, ce qui augmente la contrainte $\varepsilon_{xx}$ en compression de la deuxième couche 214 dans la direction X. Par contre, la contrainte $\varepsilon_{yy}$ en compression de la deuxième couche 214 dans la direction Y n'est pas, ou peu, impactée par les renfoncements 222, 224, ce qui crée une asymétrie de la contrainte $\varepsilon$ de la deuxième couche 214 entre la première direction X et la deuxième direction Y.

Par exemple, la contrainte $\varepsilon_{xx}$ en compression dans la direction X était de -0,6% dans le dispositif 100 des figures 1A et 1B (sans renfoncements), et elle devient inférieure à -0,6% dans le dispositif 200 de la figure 2 (avec renfoncements), c'est-à-dire que la deuxième couche 214 présente une contrainte $\varepsilon_{xx}$ en compression

15      **EP 4 694 618 A1**      16

dans la direction X supérieure (en valeur absolue) à celle des figures 1A et 1B. La contrainte $\varepsilon_{yy}$ en compression dans la direction Y peut rester sensiblement égale à -0,6%.

Dans cet exemple, on a considéré une contrainte résiduelle en tension dans la première couche 212 et une contrainte en compression dans la deuxième couche 214, mais selon les semiconducteurs de ces couches, cela peut être inversé. On peut ainsi envisager une contrainte résiduelle en compression dans la première couche 212 et une contrainte en tension dans la deuxième couche 214.

La figure 3 représente une courbe 300 donnant des valeurs de la contrainte $\varepsilon_{xx}$ de la deuxième couche 214 dans la première direction X en fonction de la cote dans cette première direction par rapport au centre C d'une structure de grille d'un dispositif quantique selon un mode de réalisation. Le dispositif quantique considéré correspond au dispositif quantique 200 de la figure 2, avec D égal à environ 2,5 $\mu$m, T égal à environ 0,5 $\mu$m et L égal à environ 1000 $\mu$m.

On peut constater que même au centre C de la structure de grille 120, du fait de la présence des renfoncements 222, 224, la contrainte $\varepsilon_{xx}$ de la deuxième couche 214 dans la première direction X a augmenté en valeur absolue, puisqu'elle est d'environ -0,673% au lieu de -0,6% sans renfoncements, cette valeur absolue de la contrainte $\varepsilon_{xx}$ augmentant encore lorsqu'on s'éloigne du centre C. L'augmentation en valeur absolue de la contrainte $\varepsilon_{xx}$ atteint son point maximal à proximité de chacune des renfoncements 222, 224, puisqu'elle est égale à environ -0,692%.

Les inventeurs ont déterminé que cette asymétrie entre les contraintes $\varepsilon_{xx}$ et $\varepsilon_{yy}$ de la deuxième couche 214, obtenue dans cet exemple en augmentant la composante $\varepsilon_{xx}$, permet d'augmenter les composantes $g_x$ et $g_y$ du tenseur gyromagnétique dans le plan XY, et notamment de réduire le rapport entre la composante $g_z$ et la composante $g_x$ et entre la composante $g_z$ et la composante $g_y$. Chacune des composantes $g_x$ et $g_y$ du tenseur gyromagnétique peut ainsi atteindre des valeurs comprises entre 0,5 et 1,5, ce qui constitue une augmentation importante (par exemple entre 5 et 7 fois) si on compare avec les valeurs indiquées plus avant, comprises entre 0,02 et 0,2. En variante, on pourrait augmenter la composante $\varepsilon_{yy}$ au lieu de la composante $\varepsilon_{xx}$, pour sensiblement les mêmes résultats sur le tenseur gyromagnétique.

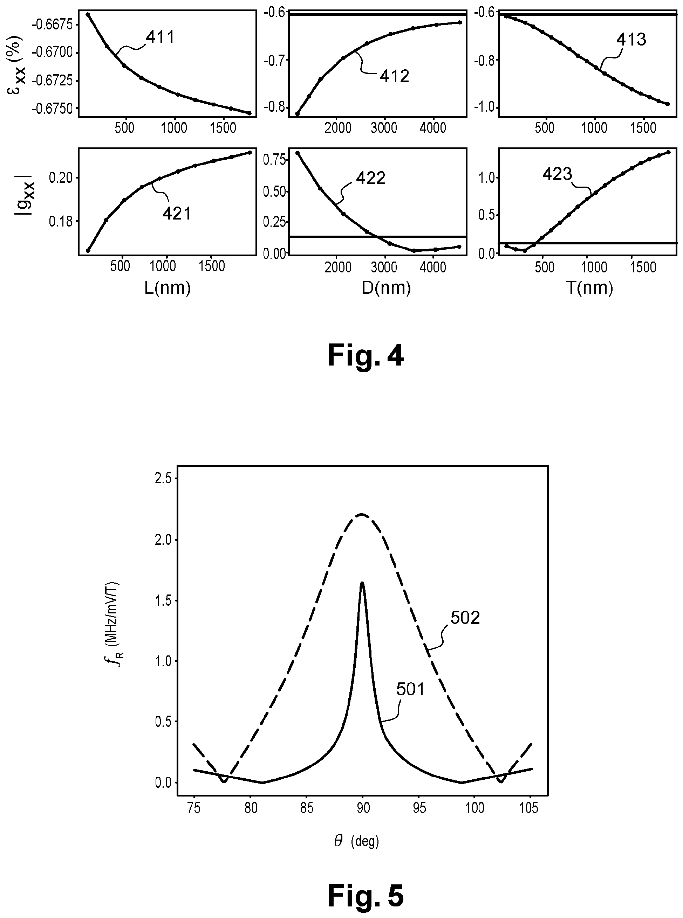

La composante $\varepsilon_{xx}$, et ainsi les composantes $g_x$ et $g_y$ peuvent notamment varier selon les valeurs de largeur L, de distance D et de profondeur T, comme décrit dans la figure 4 décrit ci-après.

La figure 4 représente des courbes donnant des valeurs de la contrainte $\varepsilon_{xx}$ et du tenseur gyromagnétique $g_{xx}$ dans la première direction X en fonction respectivement de la largeur L, la distance D et la profondeur T des renfoncements d'un dispositif quantique selon un mode de réalisation. Le dispositif quantique considéré correspond au dispositif quantique 200 de la figure 2.

La courbe 411 trace les valeurs de la composante $\varepsilon_{xx}$ de la contrainte en fonction de la largeur L. La courbe 421 trace les valeurs de la composante $g_{xx}$ du tenseur gyromagnétique en fonction de la largeur L. La courbe 412 trace les valeurs de la composante $\varepsilon_{xx}$ de la contrainte en fonction de la distance D. La courbe 422 trace les valeurs de la composante $g_{xx}$ du tenseur gyromagnétique en fonction de la distance D. La courbe 413 trace les valeurs de la composante $\varepsilon_{xx}$ de la contrainte en fonction de la profondeur T. La courbe 423 trace les valeurs de la composante $g_{xx}$ du tenseur gyromagnétique en fonction de la profondeur T.

Il ressort de ces courbes que la largeur L n'a qu'une faible d'influence sur $\varepsilon_{xx}$ et $g_{xx}$, alors que la distance D et la profondeur T ont un impact important sur $\varepsilon_{xx}$ et $g_{xx}$. Plus précisément, $\varepsilon_{xx}$ et $g_{xx}$ diminuent avec la distance D mais augmentent avec la profondeur T. En outre, W >> D.

Par exemple, la distance D peut être avantageusement inférieure à 3 $\mu$m, voire inférieure à 2,5 $\mu$m. Par exemple, la profondeur T peut être supérieure ou égale à 250 nm, voire supérieure à 500 nm. Quant à la largeur L, sachant qu'elle a peu d'impact, elle peut être choisie en fonction de la place qu'il reste dans l'empilement 210. La largeur L est bien sûr strictement supérieure à zéro pour former un renfoncement. De plus, il est possible d'avoir le rapport D/T qui soit inférieur ou égal 5. Plus généralement, le rapport D/T peut avoir une valeur strictement supérieure à 0 et inférieure ou égale à 10, et par exemple comprise (bornes incluses) entre 0,5 et 10 pour relâcher la contrainte dans la couche active dans laquelle le ou les porteurs de charge sont confinés.

Les inventeurs ont également constaté que l'augmentation des composantes $g_x$ et $g_y$ permet de rendre les dispositifs quantiques moins sensibles à un désalignement du champ magnétique par rapport au plan XY des couches semiconductrices lorsque le spin est manipulé par EDSR. Ceci est expliqué avec la figure 5 décrite dans ce qui suit.

La figure 5 représente des courbes donnant des valeurs de fréquence de Rabi $f_R$ en fonction de l'angle de désalignement $\theta$ (deg) d'un champ magnétique par rapport à l'axe perpendiculaire au plan des couches semi-conductrices de deux dispositifs quantiques.

Les courbes représentées correspondent à des résultats de simulations réalisées pour comparer un dispositif quantique selon un mode de réalisation avec un dispositif quantique de l'art antérieur. La courbe 501 (No Trench) correspond au dispositif quantique de l'art antérieur, sans renfoncement, et la courbe 502 (Optimal Trench) correspond au dispositif quantique selon le mode de réalisation. Les deux dispositifs quantiques sont comparables, mise à part les renfoncements dans le dispositif quantique selon le mode de réalisation, qui correspond au dispositif quantique 200 de la figure 2, avec D égal à environ 2 $\mu$m, T égal à environ 1 $\mu$m et L égal à environ 1000 $\mu$m.

**9**

La fréquence de Rabi est définie comme étant la fréquence d'oscillation d'un système à deux niveaux d'énergie dans un champ électromagnétique oscillatoire à une fréquence proche de la résonance du système. Dans l'exemple représenté, la fréquence de Rabi traduit la vitesse d'opération du qubit.

On constate dans la figure 5 que les courbes 501 et 502 sont sous forme de pics, avec un pic plus large pour la courbe 502 que pour la courbe 501, traduisant le fait que la présence de renforcements permet de réduire la perte de vitesse d'opération lors d'un problème de désalignement, rendant ainsi les dispositifs quantiques moins sensibles à un désalignement du champ magnétique par rapport au plan des couches semiconductrices.

Les inventeurs ont également déterminé qu'augmenter les composantes $g_x$ et $g_y$ permet de minimiser la perte d'efficacité de la manipulation de spin en utilisant le « hopping » en cas de désalignement du champ magnétique par rapport au plan XY des couches semiconductrices.

En outre, les inventeurs ont déterminé qu'augmenter les composantes $g_x$ et $g_y$ permet de réduire la variabilité sur l'énergie $\Delta E$ qu'il faut pour faire passer un qubit de spin d'un état de spin à un autre.

Dans la figure 2, les renforcements sont représentés comme étant chacun le long d'un bord de l'empilement 210, dans cet exemple un bord latéral 210C (deuxième bord), c'est-à-dire un bord qui s'étend dans la direction Y. D'autres configurations de renforcement(s) sont possibles. Les figures qui suivent montrent d'autres exemples, non limitatifs, de configurations de renforcement(s) dans l'empilement 210. Par exemple, comme décrit plus après, les renforcements peuvent ne pas être sur des bords de l'empilement, et former des tranchées.

La figure 6A et la figure 6B sont des vues de dessus et en coupe représentant un dispositif quantique 600 selon un autre mode de réalisation.

Le dispositif 600 des figures 6A et 6B diffère du dispositif 200 de la figure 2 en ce qu'il ne comprend qu'un renforcement 622 et que celui-ci n'est pas positionné le long d'un bord latéral 210C de l'empilement 210. En d'autres termes, une distance non nulle sépare le bord latéral 210C du renforcement 622, formant une tranchée (première tranchée). Ainsi, la somme de la distance D et de la largeur L de la tranchée 622 est inférieure à la moitié de la longueur LS de l'empilement 210. La tranchée 622 est à une distance non nulle du bord de la structure de grille 120.

La tranchée 622 s'étend dans la direction Y et elle est également à distance du bord longitudinal 210D (premier bord) de l'empilement 210, c'est-à-dire les bords qui s'étendent dans la direction X. Ainsi, dans l'exemple des figures 6A et 6B, la longueur W de la tranchée 622 est inférieure à la largeur WS de l'empilement 210. En variante, la tranchée 622 pourrait atteindre les bords longitudinaux 210D de l'empilement 210, c'est-à-dire la longueur W de la tranchée pourrait être égale à la largeur WS de l'empilement 210.

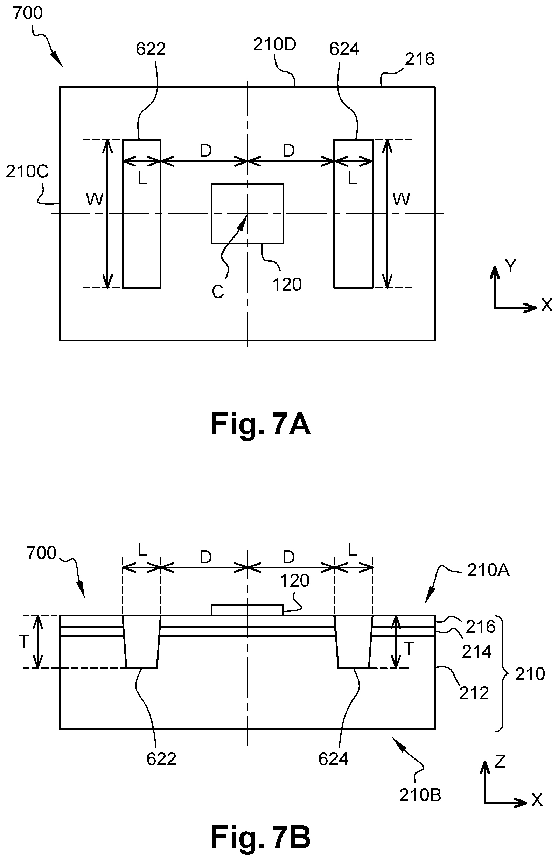

La figure 7A et la figure 7B sont des vues de dessus et en coupe représentant un dispositif quantique 700 selon un autre mode de réalisation.

Le dispositif 700 des figures 7A et 7B diffère du dispositif 200 de la figure 2 en ce que les renforcements 622 et 624 ne sont pas positionnés le long d'un bord latéral 210C de l'empilement 210. En d'autres termes, une distance non nulle sépare chacun des renforcements 622 et 624 de chaque bord latéral 210C, formant des tranchées (premières tranchées). Chaque tranchée 622, 624 s'étend dans la direction Y et est également à distance des bords longitudinaux 210D de l'empilement 210. La tranchée 622 est similaire à la tranchée décrite en lien avec les figures 6A et 6B. De plus, dans l'exemple représenté, la tranchée 624 est similaire à la tranchée 622. En d'autres termes, le dispositif 700 des figures 7A et 7B diffère du dispositif 600 des figures 6A et 6B en ce qu'il comprend une autre tranchée 624 similaire à la tranchée 622. Les tranchées 622, 624 sont à une distance non nulle du bord de la structure de grille 120.

Ce mode de réalisation est avantageux en ce qu'avoir deux tranchées allongées dans la direction Y de part et d'autre de la structure de grille 120 permet de relâcher davantage la contrainte $\varepsilon_{rxx}$ résiduelle en X de la première couche 212, et ainsi d'augmenter davantage la contrainte $\varepsilon_{xx}$ en X de la deuxième couche 214, par rapport à une seule tranchée allongée dans la direction Y, augmentant ainsi davantage les composantes $g_x$ et $g_y$ du tenseur gyromagnétique dans le plan XY.

Comme pour les renforcements 222 et 224 de la figure 2, les tranchées 622 et 624 sont positionnées de part et d'autre de la structure de grille 120, sensiblement à égale distance D du centre C. Dans l'exemple représenté, les tranchées 622 et 624 ont sensiblement la même largeur L, la même longueur W et la même profondeur T. Ceci n'est pas limitatif, et ces tranchées peuvent avoir des valeurs de distance D, de largeur L, de longueur W et/ou de profondeur T différentes.

Les inventeurs ont déterminé que, pour une distance D de 2 $\mu$m, une profondeur T de 1 $\mu$m, on peut obtenir des composantes $g_x$ et $g_y$ du tenseur gyromagnétique égales à environ 1,2, alors que la composante $g_z$ est égale à environ 14,5.

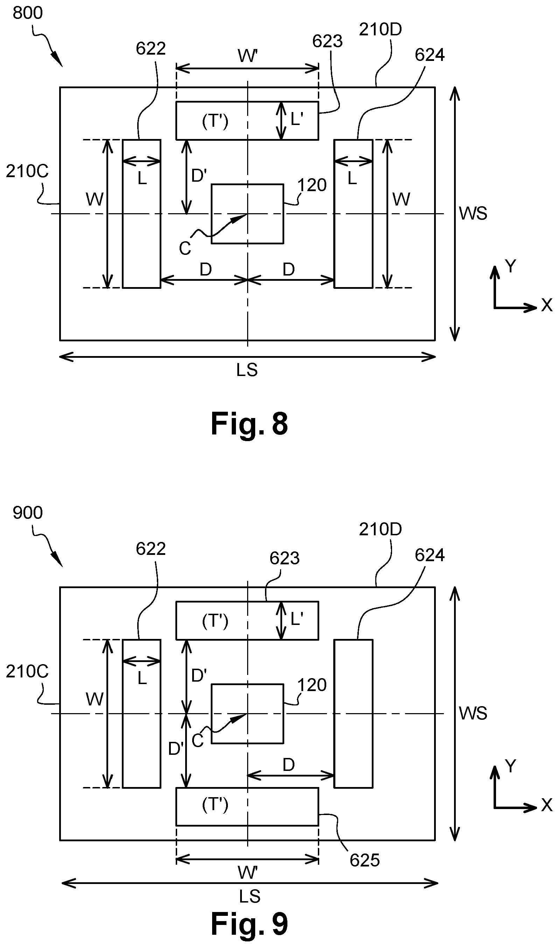

La figure 8 est une vue de dessus représentant un dispositif quantique 800 selon un autre mode de réalisation.

Le dispositif 800 de la figure 8 diffère du dispositif 700 des figures 7A et 7B en ce qu'il comprend une autre tranchée 623 (deuxième tranchée) qui s'étend également dans l'empilement 210 à partir de la première face 210A jusqu'en profondeur dans la première couche 212. La tranchée 623 présente une longueur W' dans la direction X et une largeur L' dans la direction Y. Comme par convention, la largeur L' d'une tranchée est inférieure à la longueur W', la tranchée 623 est donc allongée dans la direction X. La tranchée 623 est à une distance non nulle de la structure de grille 120, c'est-à-dire du bord de la structure de grille 120, et à une distance D' du centre C de la structure de grille 120.

La tranchée 623 est à une distance non nulle des bords longitudinaux 210D de l'empilement 210. Ainsi, la somme de la distance D' et de la largeur L' de la tranchée 623 est inférieure à la moitié de la largeur WS de l'empilement 210. La tranchée 623 est également à distance des bords latéraux 210C de l'empilement 210. Ainsi, dans l'exemple de la figure 8, la longueur W' de la tranchée 623 est inférieure à la longueur LS de l'empilement 210. En variante, la tranchée 623 pourrait atteindre les bords latéraux 210C de l'empilement 210, c'est-à-dire la longueur W' de la tranchée 623 pourrait être égale à la longueur LS de l'empilement 210.

La figure 9 est une vue de dessus représentant un dispositif quantique 900 selon un autre mode de réalisation.

Le dispositif 900 de la figure 9 diffère du dispositif 800 de la figure 8 en ce qu'il comprend une autre tranchée 625 (deuxième tranchée), qui est de préférence similaire à la tranchée 623.

Les tranchées 623 et 625 (deuxièmes tranchées) sont positionnées de part et d'autre de la structure de grille 120, sensiblement à égale distance D' du centre C de la structure de grille 120. Dans l'exemple représenté, les tranchées 623 et 625 ont sensiblement la même largeur L', la même longueur W' et la même profondeur T' (représentée entre parenthèse sur les figures 8 et 9). Ceci n'est pas limitatif, et les tranchées 623 et 625 peuvent avoir des valeurs de distance D', de largeur L', de longueur W' et/ou de profondeur T' différentes. Les tranchées 623, 625 sont à une distance non nulle du bord de la structure de grille 120.

Dans l'exemple représenté, les tranchées 623 et 625 (deuxièmes tranchées) sont similaires aux tranchées 622 et 624 (premières tranchées), à ceci près qu'elles sont tournées à 90°. Ceci n'est pas limitatif, et toutes ces tranchées peuvent avoir des valeurs de distance D, D', de longueur W, W', de longueur L, L' et/ou de profondeur T, T' différentes entre elles. De plus, les formes des sections de ces tranchées peuvent être rectangulaires ou d'une toute autre forme.

Un avantage à avoir trois ou quatre tranchées de part et d'autre de la structure de grille 120, dont au moins une allongée dans la direction Y et au moins une allongée dans la direction X, est que cela peut permettre d'agir de manière différenciée sur le relâchement de la contrainte résiduelle $\varepsilon_{rxx}$ en X et de la contrainte résiduelle $\varepsilon_{ryy}$ en Y dans la première couche 212, et ainsi d'agir de manière différenciée sur la contrainte $\varepsilon_{xx}$ en X et la contrainte $\varepsilon_{yy}$ en Y dans la deuxième couche 214, par exemple en jouant de manière différenciée sur les valeurs de distance D', de largeur L', de longueur W' et/ou de profondeur T' des tranchées allongées en X, et/ou sur les valeurs de distance D, de largeur L, de longueur W et/ou de profondeur T des tranchées allongées en Y.

En effet, dans certaines applications, comme par exemple des applications de manipulation de qubits de spin exploitant la magnétorésistance à effet tunnel (g-TMR, de l'anglais « g-Tensor Modulation Resonance »), en particulier exploitant le couplage spin-orbit (SOC, de l'anglais Spin Orbit Coupling), il peut être intéressant de jouer sur les deux composantes $\varepsilon_{xx}$ et $\varepsilon_{yy}$ dans le plan XY de la contrainte $\varepsilon$ et/ou de jouer sur la valeur de la somme de ces deux composantes pour contrôler l'intensité du couplage spin-orbit.

Dans les modes de réalisation décrits en lien avec les figures 6A à 9 :

- la distance D, D' de chaque tranchée est avantageusement inférieure ou égale à 2,5 $\mu$m ; par exemple, la distance D, D' est comprise entre 500 nm et 2,5 $\mu$m, bornes incluses ;
- la profondeur T, T' de chaque tranchée est avantageusement supérieure ou égale à 250 nm ; par exemple, la profondeur T, T' est comprise entre 250 nm et 1 $\mu$m, bornes incluses ;
- la largeur L, L' de chaque tranchée, sachant qu'elle a peu d'impact, est supérieure à zéro et peut être augmentée, dans la limite de la place dans l'empilement 210 de couches semiconductrices.

La longueur W de chaque tranchée allongée en Y est inférieure ou égale à la largeur WS de l'empilement 210. La longueur W' de chaque tranchée allongée en X est inférieure ou égale à la longueur LS de l'empilement 210.

Lorsque les longueurs W des tranchées 622 et 624 allongées dans la direction Y sont chacune égales à la largeur WS de l'empilement 210, et que les longueurs W' des tranchées 623 et 625 allongées dans la direction X sont chacune égale à la longueur LS de l'empilement 210, on peut obtenir une tranchée continue autour de la structure de grille 120.

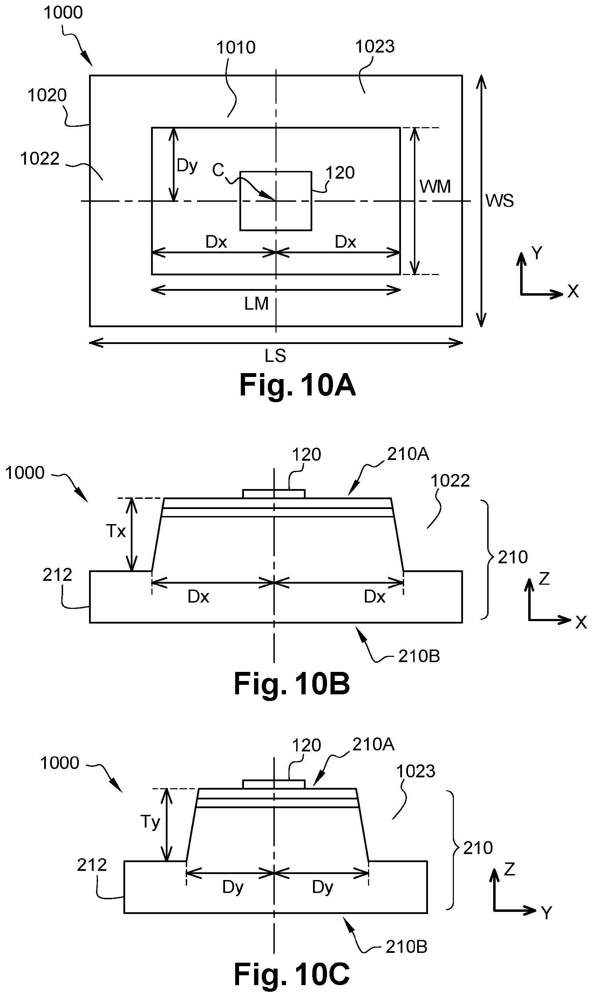

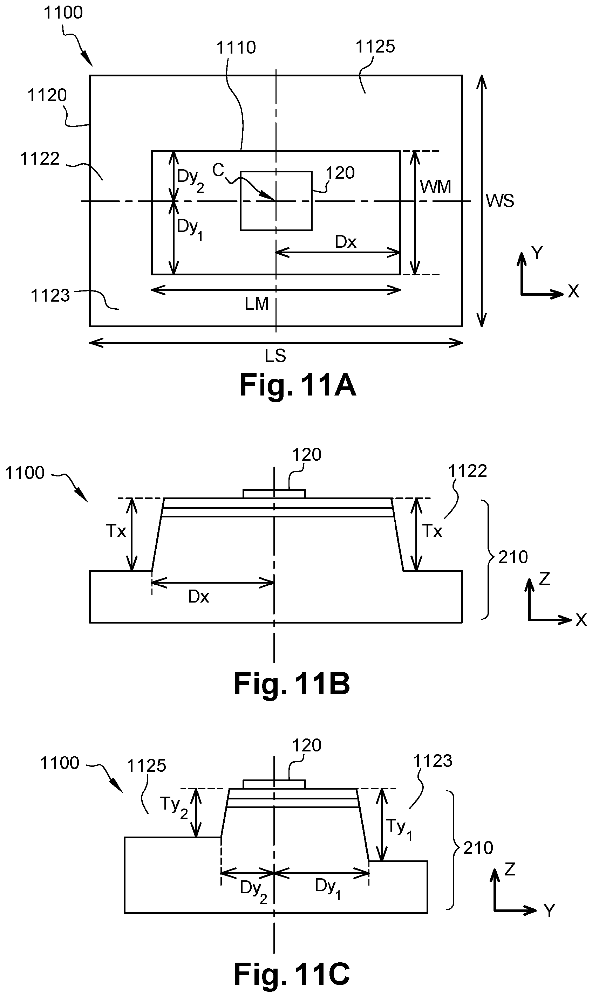

Lorsque les renfoncements allongés dans la direction Y sont positionnés le long des bords latéraux 210C de l'empilement 210 et que la longueur W est égale à la largeur WS de l'empilement 210, et que les renfoncements allongés dans la direction X sont positionnés le long des bords longitudinaux 210D de l'empilement 210, et que la longueur W' est égale à la longueur LS de l'empilement 210, on peut obtenir un renfoncement continu qui s'étend sur toute la périphérie de l'empilement 210, autour de la structure de grille 120. On peut parler de renfoncement périphérique. Ce renfoncement périphérique définit, et encadre, un ilot correspondant à une portion non périphérique de l'empilement 210. La structure de grille 120 est positionnée au-dessus de cet ilot, et la portion de la deuxième couche 214 positionnée sous la structure de grille 120 est comprise dans cet ilot. Les figures 10A, 10B, 11A et 11B décrites dans ce qui suit illustrent des exemples, non limitatifs, de renfoncement périphérique autour d'un ilot.

La figure 10A, la figure 10B et la figure 10C sont des vues de dessus et en coupe représentant un dispositif quantique 1000 selon un autre mode de réalisation.

Le dispositif quantique 1000 des figures 10A à 10C diffère du dispositif quantique 100 des figures 1A et 1B en ce qu'il comprend un renfoncement périphérique 1020 sur toute la périphérie de l'empilement 210, tout autour de la structure de grille 120. Comme pour les renfoncements et tranchées décrits précédemment, ce renfoncement périphérique 1020 s'étend dans l'empilement 210 à partir de la première face 210A (face supérieure) de cet empilement jusqu'en profondeur dans la première couche 212, c'est-à-dire à travers la troisième couche 216 et la deuxième couche 214, et partiellement dans la première couche 212. Le renfoncement périphérique 1020 définit un ilot 1010, qui est dans cet exemple centré par rapport à l'empilement 210.

Le renfoncement périphérique 1020 comprend des portions 1022 (premières portions) qui s'étendent dans la direction Y et des portions 1023 (deuxièmes portions) qui s'étendent dans la direction X. La profondeur du renfoncement périphérique 1020 dans l'empilement 210 est désignée par la référence Tx dans les portions 1022 et par la référence Ty dans les portions 1023. Les valeurs de Tx et Ty peuvent identiques ou non de chaque côté des axes de symétrie de l'ilot. Le renfoncement périphérique 1020 est à une distance non nulle de la structure de grille 120, qui est positionnée sur l'ilot 1010, c'est-à-dire à une distance non nulle du bord de la structure de grille 120. La distance D entre le renfoncement périphérique 1020 et le centre C de la structure de grille 120 est désignée par la référence Dx pour les portions 1022 et par la référence Dy pour les portions 1023.

Dans l'exemple des figures 10A à 10C, on a représenté un ilot 1010 de forme rectangulaire avec un côté plus grand qu'un autre, par exemple avec une distance Dx supérieure à la distance Dy. Par exemple, Dx et Dy peuvent être égales à quelques micromètres, par exemple inférieures à 5 $\mu$m ou comprises entre 3 et 5 $\mu$m.

En variante, l'ilot peut avoir une forme rectangulaire plus prononcée, avec une distance Dx très supérieure à la distance Dy. Par exemple, Dx pourrait être égale à quelques micromètres, voire être inférieure à 5 $\mu$m, et Dy pourrait être inférieure à 2,5 $\mu$m, ou inversement Dy pourrait être égale à quelques micromètres, voire être inférieure à 5 $\mu$m, et Dx pourrait être inférieure à 2,5 $\mu$m. Les inventeurs ont déterminé que, dans cette variante, la composante $\varepsilon_{yy}$ de la contrainte en compression $\varepsilon$ dans la deuxième couche 214 pouvait être rendue très inférieure à -0,6%. Similairement, la valeur absolue de la composante $\varepsilon_{xx}$ de la contrainte en compression $\varepsilon$ dans la deuxième couche 214 pourrait être rendue très inférieure à -0,6% avec une distance Dy très supérieure à la distance Dx.

Dans l'exemple des figures 10A à 10C, les portions 1022 sont sensiblement à la même distance Dx du centre C, les portions 1023 sont sensiblement à la même distance Dy du centre C, l'ilot 1010 est ainsi sensiblement centré par rapport à l'empilement 210. De plus, dans l'exemple des figures 10A à 10C, les portions 1022 et 1023 ont toutes sensiblement la même profondeur, c'est-à-dire que Tx est sensiblement égal à Ty. Cet exemple est non limitatif, et d'autres configurations peuvent être envisagées par la personne du métier. Par exemple, l'ilot peut ne pas être centré, les premières portions n'ont pas nécessairement toutes les mêmes profondeurs, les deuxièmes portions n'ont pas nécessairement toutes les mêmes profondeurs, et/ou les premières et deuxièmes portions n'ont pas nécessairement les mêmes profondeurs.

La figure 11A, la figure 11B et la figure 11C sont des vues de dessus et en coupe représentant un dispositif quantique 1100 selon un autre mode de réalisation.

D'une part, les figures 11A à 11C illustrent la variante décrite ci-dessus dans laquelle la distance Dx est très supérieure à la distance Dy.

D'autre part, le dispositif 1100 des figures 11A à 11C diffère du dispositif 1000 des figures 10A à 10C en ce que l'ilot 1110 est décentré par rapport au centre C de la structure de grille 120 dans la direction Y. Le renfoncement périphérique 1120 est à une distance non nulle du bord de la structure de grille 120, qui est positionnée sur l'ilot 1110. Le renfoncement périphérique 1120 comprend des portions 1122 (premières portions) qui s'étendent dans la direction Y et des portions 1123, 1125 (deuxièmes portions) qui s'étendent dans la direction X. Le décentrage provient du fait que la portion 1123 est plus proche du centre C que la portion 1125. En d'autres termes, la distance Dy1 entre la portion 1123 et le centre C est supérieure à la distance Dy2 entre la portion 1125 et le centre C. En d'autres termes, la portion 1125 est plus large que la portion 1123.

En outre, les profondeurs Ty1 et Ty2 des deux portions 1123 et 1125 sont différentes. Dans l'exemple représenté, la profondeur Ty1 de la portion 1123 est supérieure à la portion Ty2 de la portion 1125, mais ce peut être l'inverse.

Les inventeurs ont déterminé que, pour le mode de réalisation des figures 11A à 11C, avec Dx supérieur à 10 $\mu$m, et Dy2 inférieur à 2,5 $\mu$m, la composante $\varepsilon_{yy}$ de la contrainte $\varepsilon$ dans la deuxième couche 214 diminue, par exemple est rendue très inférieure à -0,6%, alors que la composante $\varepsilon_{xx}$ de la contrainte $\varepsilon$ est maintenue à environ -0,6%.

Dans l'exemple des figures 11A à 11C, les portions 1122 étendues dans la direction Y sont similaires, c'est-à-dire la distance Dx est sensiblement identique pour les deux portions 1122, ainsi que la profondeur Tx. En variante, l'ilot 1110 pourrait être décentré par rapport au centre C de la structure de grille 120 dans la direction X, en complément ou à la place du décentrage dans la direction Y. En variante, la profondeur Tx pourrait être différente entre les deux portions 1122. On pourrait ainsi agir également sur la composante $\varepsilon_{yy}$ de la contrainte $\varepsilon$.

Dans les modes de réalisation des figures 10A à 11C :

- les profondeurs Tx, Ty, Ty1, Ty2 des portions du renforcement périphérique sont de préférence supérieures ou égales à 250 nm ;
- les distances Dx, Dy, Dy1, Dy2 des portions du renforcement périphérique par rapport au centre C sont de préférence inférieures ou égales à 5 $\mu$m.

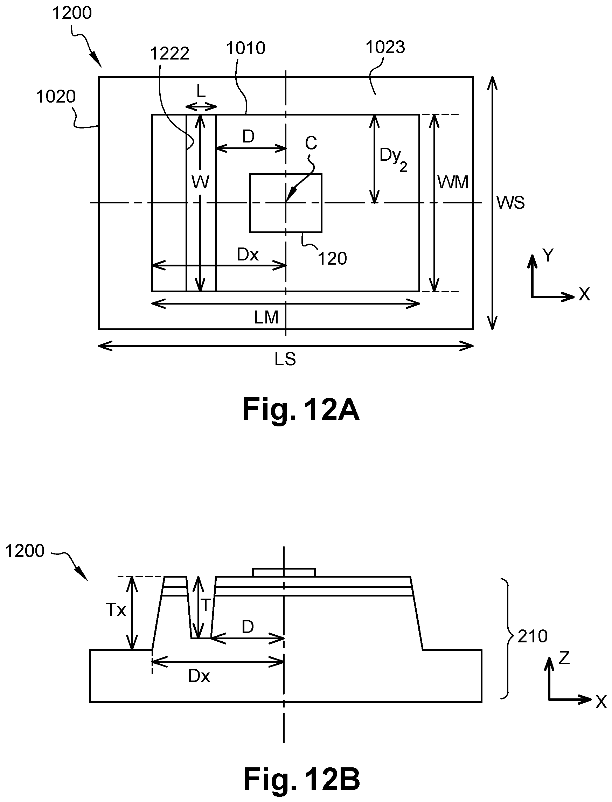

La figure 12A et la figure 12B sont des vues de dessus et en coupe représentant un dispositif quantique selon un autre mode de réalisation.

Le dispositif 1200 des figures 12A et 12B diffère du dispositif 1000 des figures 10A à 10C en ce qu'il comprend en outre, en plus du renforcement périphérique 1020, une tranchée 1222 dans l'ilot 1010. La tranchée 1222 est à une distance non nulle du bord de la structure de grille 120, qui est positionnée sur l'ilot 1010.

On a représenté en figure 12A et 12B une seule tranchée 1222 étendue dans la direction Y ayant une largeur W égale à la largeur WM de l'ilot 1010, mais la largeur W peut être inférieure à la largeur WM de l'ilot 1010 dans d'autres modes de réalisation. D'autres variantes peuvent être envisagées par la personne du métier. Notamment, on peut avoir un ilot décentré, comme décrit en lien avec les figures 11A à 11C. Notamment, on peut combiner le mode de réalisation des figures 10A à 10C ou des figures 11A à 11C avec chacun des modes de réalisation des figures 6A à 9, c'est-à-dire prévoir une ou plusieurs tranchées dans la direction X et/ou la direction Y, dans l'ilot 1010 formé dans l'empilement 210. Les exemples de distance D, de profondeur T, de largeur L et de longueur W décrits en lien avec les figures 6A à 9 peuvent s'appliquer à une ou plusieurs tranchées dans un ilot, sachant qu'on considère alors la longueur LM et la largeur WM de l'ilot plutôt que la longueur LS et la largeur WS de l'empilement.

Les inventeurs ont déterminé que, pour le mode de réalisation des figures 12A et 12B, la composante $\varepsilon_{xx}$ de la contrainte $\varepsilon$ dans la deuxième couche 214 diminue, par exemple est très en dessous de -0,6%, alors que la composante $\varepsilon_{xx}$ de la contrainte $\varepsilon$ est maintenue à environ -0,6%. La composante $\varepsilon_{yy}$ est également inférieure à -0,6% lorsque Dy est inférieure à 3 $\mu$m, avec toutefois $\varepsilon_{yy}$ > $\varepsilon_{xx}$.

Les exemples des figures 2, 6A à 12B montrent qu'on peut agir sur plusieurs paramètres, tels que le nombre de renforcements, le type de renforcements (tranchée(s), renforcement(s) au bord de l'empilement, renforcement périphérique), les profondeurs des renforcements ou des portions de renforcement, les distances des renforcements ou des portions de renforcement par rapport au centre de la structure de grille et/ou au bord de la structure de grille, voire, dans une moindre mesure, les largeurs et les longueurs des renforcements, et qu'on peut faire varier ces paramètres selon les renforcements ou les portions de renforcement, pour agir sur la composante $\varepsilon_{xx}$ et/ou la composante $\varepsilon_{yy}$ de la contrainte $\varepsilon$ dans la deuxième couche 214, et ainsi avoir un impact positif en termes de variabilité (pour diminuer celle-ci), de sensibilité du dispositif quantique vis-à-vis du désalignement du champ magnétique (pour diminuer celle-ci), plus généralement pour améliorer les performances du dispositif quantique.

Les renforcements peuvent être formés par des procédés standards de formation de tranchées dans des couches de semiconducteur. On décrit ici, à titre d'illustration non limitative, un exemple de procédé de réalisation de renforcements, le procédé comprenant :

- le dépôt, optionnel, d'une fine de couche de protection, par exemple une couche de $SiO_2$ d'épaisseur comprise entre 2 et 5 nm, sur la face supérieure de l'empilement de couches semiconductrices ;
- la formation par lithographie d'un masque de gravure sur face supérieure de l'empilement de couches semiconductrices, éventuellement recouverte de la fine couche de protection, le masque de gravure comprenant des ouvertures dont les motifs correspondent aux formes dans le plan de l'empilement, des renforcements à former ;
- la gravure de l'empilement de couches semiconductrice, à partir de la face supérieure et à travers le masque de gravure, et ce, en profondeur jusque dans la première couche ; puis
- le retrait du masque de gravure.

Pour former des renforcements au bord de l'empilement, on positionne les ouvertures du masque de gravure au bord de l'empilement.

Dans le cas d'un renforcement périphérique, le retrait du masque de gravure peut être suivi d'une étape de planarisation de l'ilot.

On décrit en particulier dans ce qui suit deux exemples de procédés de réalisation d'un renforcement périphérique.

Un premier exemple de procédé de réalisation consiste à réaliser le renforcement périphérique à la fin du processus dit "front end of line" (FEOL), c'est-à-dire le processus de fabrication des composants électroniques dans les couches semiconductrices, et avant le processus de formation de la structure d'interconnexion, dit "back end of line" (BEOL). Le processus BEOL peut être adapté, notamment l'épaisseur de la couche diélectrique en PMD, Pre-Métal diélectrique pour pouvoir remplir en PMD le renforcement.

Un deuxième exemple de procédé de réalisation consiste à réaliser le renforcement périphérique avant le processus FEOL, le renforcement périphérique pouvant être rempli ensuite avec un matériau qui n'est pas nécessairement du PMD.

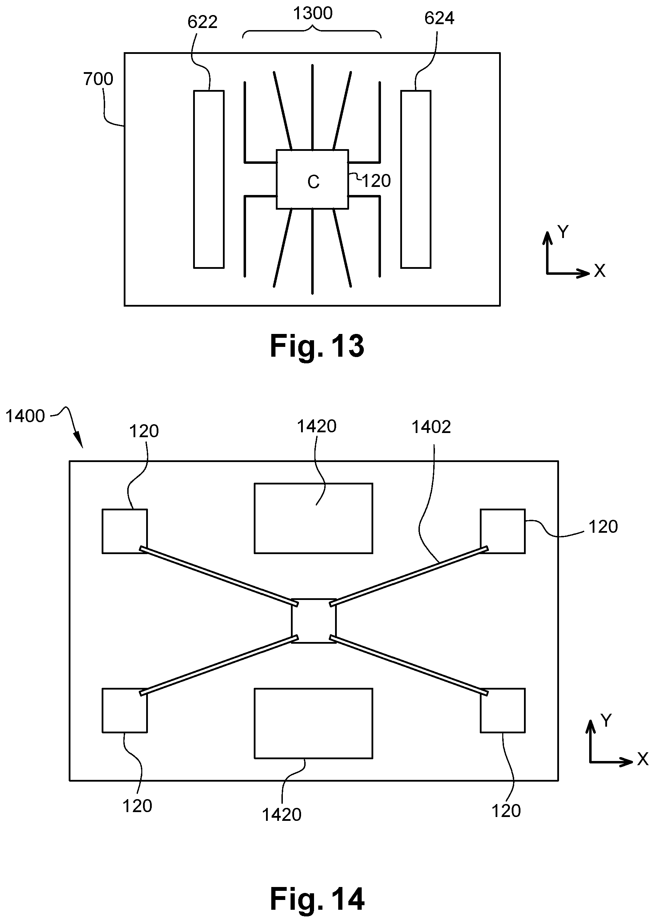

La figure 13 est une vue de dessus représentant un dispositif quantique selon un autre mode de réalisation. Ce mode de réalisation correspond à celui des figures 7A et 7B, avec en outre des pistes d'interconnexions 1300 reliées à la structure de grille 120. La figure 13 montre que la présence de renfoncements n'empêche pas l'interconnexion des grilles de contrôle, les pistes pouvant contourner le (ou les) renfoncement(s). Lorsque le ou les renfoncements sont remplis d'un matériau diélectrique, les contacts peuvent passer au-dessus du ou des renfoncements.

La figure 14 est une vue de dessus représentant un dispositif quantique 1400 selon un autre mode de réalisation.

Ce dispositif quantique 1400 comprend plusieurs structures quantiques (représentés par plusieurs structures de grille 120) reliés par des coupleurs de qubit longue distance 1402, avec des renfoncements 1420 entre les qubits qui peuvent être similaire à l'un ou l'autres des renfoncements décrits précédemment.

Dans les différents exemples de réalisation précédemment décrits, les hétérostructures sont formées par les première, deuxième et troisième couches semiconductrices. En variante, il est possible que la ou les hétérostructures comportent plus de trois couches semiconductrices. Dans les différentes configurations possibles, le ou les renfoncements sont formés à travers au moins la couche adaptée au confinement du ou des porteurs de charge ainsi que les couches reposant sur cette couche de confinement.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, le renfoncement (les renfoncements) peu(ven)t être remplie(s), par exemple en un matériau diélectrique, par exemple en $SiO_2$ ou en $Al_2O_3$, le remplissage étant réalisé après la relaxation de contrainte dans la première couche.

Enfin, la mise en oeuvre pratique des modes de réalisation et variantes décrits est à la portée de la personne du métier à partir des indications fonctionnelles données ci-dessus.

**Revendications**

1. Dispositif quantique (200 ; 600 ; 700 ; 800 ; 900 ; 1000 ; 1100 ; 1200 ; 1400) à qubits, le dispositif quantique comprenant :

   - un empilement (210) de couches semiconductrices s'étendant dans un plan (XY), l'empilement incluant au moins une première couche (212) d'un premier semiconducteur sur un substrat semiconducteur (102), une deuxième couche (214) d'un deuxième semiconducteur sur la première couche (212), et une troisième couche (216) d'un troisième semiconducteur sur la deuxième couche (214), la deuxième couche étant adaptée à confiner un porteur de charge, et les premier et troisième semiconducteurs présentant chacun un paramètre de maille différent du paramètre de maille du deuxième semiconducteur, de sorte que la deuxième couche présente une contrainte ($\varepsilon$) dans le plan, la première couche ayant en outre une contrainte résiduelle ($\varepsilon_r$) dans le plan ;

   - une structure de grille (120), comprenant au moins une grille de contrôle, positionnée au-dessus d'une première face (210A) de l'empilement, ladite structure de grille étant adaptée à contrôler le déplacement du porteur de charge confiné dans la deuxième couche ; et

   - au moins un renfoncement (222, 224 ; 622, 624, 623, 625 ; 1020 ; 1120 ; 1222) s'étendant à partir de la première face (210A) à travers au moins les troisième et deuxième couches, ledit au moins un renfoncement étant situé à une distance (D, D'), non nulle, d'un centre de la structure de grille (120) dans le plan (XY) et ayant une profondeur (T, T') tel que le rapport de la distance (D, D') sur la profondeur (T, T') soit compris entre une valeur strictement supérieure à 0 et inférieure ou égale à 10.

2. Dispositif quantique (200 ; 600 ; 700 ; 800 ; 900 ; 1200) selon la revendication 1, dans lequel le plan (XY) inclut une première direction (X) et une deuxième direction (Y), le au moins un renfoncement comprenant au moins un premier renfoncement (222, 224 ; 622, 624 ; 1222) étendu dans la deuxième direction (Y) ou deux premiers renfoncements (222, 224 ; 622, 624) positionnés de part et d'autre de la structure de grille (120) dans la première direction (X).

3. Dispositif quantique (800 ; 900) selon la revendication 2, dans lequel le au moins un renfoncement comprend en outre au moins un deuxième renfoncement (623, 625) étendu dans la première direction (X) ou deux deuxièmes renfoncements (623, 625) de part et d'autre de la structure de grille (120) dans la deuxième direction (Y).

4. Dispositif quantique (800 ; 900) selon la revendication 3, dans lequel le au moins un deuxième renfoncement (623, 625) inclut au moins une deuxième tranchée et/ou est positionné en un premier bord (210D) de l'empilement (210).

5. Dispositif quantique (600 ; 700 ; 800 ; 900) selon l'une quelconque des revendications 2 à 4, dans lequel le au moins un premier renfoncement (622, 624) inclut au moins une première tranchée et/ou est positionné en un deuxième bord (210C) de l'empilement (210).

6. Dispositif quantique selon l'une quelconque des revendications précédentes, dans lequel, pour chaque renfoncement :

- la distance (D, D') est inférieure ou égale à 2,5 μm, et par exemple supérieure ou égale à 0,5 μm ; et/ou
- la profondeur (T, T') est supérieure ou égale à 0,25 μm, et par exemple inférieure ou égale à 1 μm ; et/ou
- une longueur (W ; W') de chaque renfoncement est supérieure ou égale à la distance (D ; D').

7. Dispositif quantique (1000 ; 1100 ; 1200) selon l'une quelconque des revendications précédentes, dans lequel le au moins un renfoncement comprend un renfoncement périphérique (1020 ; 1120) s'étendant sur toute la périphérie de l'empilement (210) autour de la structure de grille (120), ledit renfoncement périphérique définissant un ilot (1010 ; 1110) correspondant à une portion non périphérique de l'empilement (210).

8. Dispositif quantique (1200) selon la revendication 7 dans sa dépendance avec l'une quelconque des revendications 2 à 5, dans lequel le au moins une premier renfoncement (1222) est localisé dans l'ilot (1010).

9. Dispositif quantique selon la revendication 7 ou 8 dans sa dépendance avec l'une quelconque des revendications 3 ou 4, dans laquelle le au moins un deuxième renfoncement est localisé dans l'ilot.

10. Dispositif quantique (1000 ; 1200) selon l'une quelconque des revendications 7 à 9, dans lequel le renfoncement périphérique (1020) a une seule profondeur, par exemple ladite profondeur est supérieure ou égale à 0,25 μm, ou dans lequel le renfoncement périphérique (1120) présente plusieurs profondeurs (Tx, Ty1, Ty2) différentes, par exemple lesdites profondeurs sont toutes supérieures ou égales à 0,25 μm.

11. Dispositif quantique selon l'une quelconque des revendications 7 à 10, dans lequel l'une parmi la contrainte (ε) et la contrainte résiduelle (ε$_r$) est une contrainte en compression, tandis que l'autre est une contrainte en tension.

12. Dispositif quantique selon l'une quelconque des revendications 7 à 11, dans lequel :

- les couches semiconductrices de l'empilement (210) sont des couches épitaxiales ; et/ou
- l'énergie de bande interdite du deuxième semiconducteur est inférieure à l'énergie de bande interdite de chacun des premier et troisième semiconducteurs ; et/ou
- les premières et troisièmes couches forment chacune une barrière de potentiel de confinement vis-à-vis du porteur de charge dans la deuxième couche ; et/ou
- les premier et troisième semiconducteurs sont en un alliage silicium-germanium et le deuxième semiconducteur est le germanium.

13. Dispositif quantique (200 ; 600 ; 700 ; 800 ; 900 ; 1000 ; 1100 ; 1200 ; 1400) selon l'une quelconque des revendications précédentes, dans lequel ledit au moins un renfoncement (222, 224 ; 622, 624, 623, 625 ; 1020 ; 1120 ; 1222) est rempli par au moins un matériau diélectrique.

14. Dispositif quantique (200 ; 600 ; 700 ; 800 ; 900 ; 1000 ; 1100 ; 1200 ; 1400) selon l'une quelconque des revendications précédentes, dans lequel chaque renfoncement est à une distance non nulle du bord de la structure de grille (120).

15. Procédé de réalisation d'un dispositif quantique (200 ; 600 ; 700 ; 800 ; 900 ; 1000 ; 1200 ; 1400) à qubits, comprenant au moins :

- réalisation d'un empilement (210) de couches semiconductrices s'étendant dans un plan (XY), l'empilement incluant au moins une première couche (212) d'un premier semiconducteur sur un substrat semiconducteur (102), une deuxième couche (214) d'un deuxième semiconducteur sur la première couche (212), et une troisième couche (216) d'un troisième semiconducteur sur la deuxième couche (214), la deuxième couche étant adaptée à confiner un porteur de charge, et les premier et troisième semiconducteurs présentant chacun un paramètre de maille différent du paramètre de maille du deuxième semiconducteur, de sorte que la deuxième couche présente une contrainte (ε) dans le plan, la première couche ayant en outre une contrainte résiduelle (ε$_r$) dans le plan ;
- réalisation d'une structure de grille (120), comprenant au moins une grille de contrôle, positionnée au-dessus d'une première face (210A) de l'empilement, ladite structure de grille étant adaptée à contrôler le déplacement du porteur de charge confiné dans la deuxième couche ; et
- réalisation d'au moins un renfoncement (222, 224 ; 622, 624, 623, 625 ; 1020 ; 1120 ; 1222) s'étendant à partir de la première face (210A) à travers au moins les troisième et deuxième couches, ledit au moins un renfoncement étant situé à une distance (D, D'), non nulle, d'un centre de la structure de grille (120) dans le plan (XY) et ayant une profondeur (T, T') tel que le rapport de la distance (D, D') sur la profondeur (T, T') soit compris entre une valeur strictement supérieure à 0 et inférieure ou égale à 10.

**Fig. 1A**

**Fig. 1B**

**Fig. 2**

**Fig. 3**

## Fig. 4

## Fig. 5

**Fig. 6A**

**Fig. 6B**

**Fig. 7A**

**Fig. 7B**

**Fig. 8**

**Fig. 9**

**Fig. 10A**

**Fig. 10B**

**Fig. 10C**

**Fig. 11A**

**Fig. 11B**

**Fig. 11C**

**Fig. 12A**

**Fig. 12B**

**Fig. 13**

**Fig. 14**

Europäisches
Patentamt

European
Patent Office

Office européen
des brevets

## RAPPORT DE RECHERCHE EUROPEENNE

Numéro de la demande

EP 25 19 1129

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | EP 1 262 911 A1 (HITACHI EUROP LTD [GB]) 4 décembre 2002 (2002-12-04) * Figures 1, 2, 5, 12, 13, 16 et texte correspondant.; alinéa [0034] * | 1-6, 13-15 | INV. H10D48/00 H10D62/10 H10D64/27 |
| X | US 2007/194297 A1 (MCCARTHY WIL [US] ET AL) 23 août 2007 (2007-08-23) * Figures 2-6 et texte correspondant. * | 1,2, 6-12,14, 15 | ADD. B82Y10/00 |
| A | EP 3 660 921 A1 (COMMISSARIAT ENERGIE ATOMIQUE [FR]) 3 juin 2020 (2020-06-03) * Figures 4, 9, 13, 15 et texte correspondant. * | 1-15 | |
| A | US 2013/221330 A1 (CHOI JUNG BUM [KR] ET AL) 29 août 2013 (2013-08-29) * Figures 4-7 et texte correspondant. * | 1-15 | |
| A | FR 3 143 798 A1 (COMMISSARIAT ENERGIE ATOMIQUE [FR]) 21 juin 2024 (2024-06-21) * Figures 1-3 et texte correspondant. * | 1-15 | DOMAINES TECHNIQUES RECHERCHES (IPC) H10D B82Y |

Le présent rapport a été établi pour toutes les revendications

| Lieu de la recherche | Date d'achèvement de la recherche | Examinateur |
|---|---|---|
| Munich | 19 décembre 2025 | Dauw, Xavier |

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 25 19 1129

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

19-12-2025

| Document brevet cité au rapport de recherche | | Date de publication | Membre(s) de la famille de brevet(s) | | Date de publication |
|---|---|---|---|---|---|
| EP 1262911 | A1 | 04-12-2002 | EP | 1262911 A1 | 04-12-2002 |
| | | | JP | 4213892 B2 | 21-01-2009 |
| | | | JP | 2003086788 A | 20-03-2003 |
| | | | US | 2002190249 A1 | 19-12-2002 |
| US 2007194297 | A1 | 23-08-2007 | AU | 2007238477 A1 | 25-10-2007 |
| | | | CA | 2647105 A1 | 25-10-2007 |
| | | | CN | 101405866 A | 08-04-2009 |
| | | | EP | 1989737 A1 | 12-11-2008 |
| | | | US | 2007194297 A1 | 23-08-2007 |
| | | | WO | 2007120983 A1 | 25-10-2007 |
| EP 3660921 | A1 | 03-06-2020 | EP | 3660921 A1 | 03-06-2020 |
| | | | FR | 3089213 A1 | 05-06-2020 |
| | | | US | 2020185497 A1 | 11-06-2020 |
| US 2013221330 | A1 | 29-08-2013 | KR | 20120048453 A | 15-05-2012 |
| | | | US | 2013221330 A1 | 29-08-2013 |
| | | | WO | 2012060505 A1 | 10-05-2012 |
| FR 3143798 | A1 | 21-06-2024 | EP | 4391068 A1 | 26-06-2024 |
| | | | FR | 3143798 A1 | 21-06-2024 |
| | | | US | 2025017120 A1 | 09-01-2025 |

EPO FORM P0460

Pour tout renseignement concernant cette annexe : voir Journal Officiel de l'Office européen des brevets, No.12/82